Europäisches Patentamt

European Patent Office

Office européen des brevets

(11) Publication number: **0 134 396**
**A1**

## EUROPEAN PATENT APPLICATION

(21) Application number: **84104124.7**

(22) Date of filing: **12.04.84**

(51) Int. Cl.⁴: **G 03 F 3/04**
**G 03 B 27/73**

(30) Priority: **17.08.83 JP 150642/83**
**23.08.83 JP 130529/83**

(43) Date of publication of application:
**20.03.85 Bulletin 85/12**

(84) Designated Contracting States:
**AT BE CH DE FR GB IT LI LU NL SE**

(71) Applicant: **KABUSHIKI KAISHA UESHINA BUNMEIDO**
**195, Ayazaimokucho Takakurahigashiiru**
**Ayanokojidori Shimogyo-ku Kyoto-shi(JP)**

(72) Inventor: **Ueshina, Toshima**
**195, Ayazaimokucho Takakurahigashiiru**
**Ayanokojidori Shimogyo-ku Kyoto-shi(JP)**

(74) Representative: **Finck, Dieter et al,**
**Patentanwälte v. Füner, Ebbinghaus, Finck Mariahilfplatz**
**2 & 3**
**D-8000 München 90(DE)**

(54) Method and apparatus for proofing multicolor prints.

(57) Each color decomposed negative plate (A) is placed on an illuminating box (1) and its image is projected upon a photosensitive member (20) in a pack (15) through a rotatable filter (8), a lens (9) and a motor-driven shutter (10). The plate (A), lens (9) and pack (15) are disposed along the same optical axis. A controller (14) is provided for projecting image of the plate (A) upon the photosensitive member (20), and for operating the shutter (10). By sequentially projecting image of the plates (A) by using filters of corresponding colors, a color photograph is obtained which is used for proofing. With this proofing, the proofing time can be reduced greatly.

FIG. 1

EP 0 134 396 A1

v . F Ü N E R          E B B I N G H A U S          I N C K

P A T E N T A N W Ä L T E          E U R O P E A N  P A T

MARIAHILFPLATZ 2 & 3, MÜNC

POSTADRESSE: POSTFACH 95 01 60, D-8000 MÜNCHEN 95

KABUSHIKI KAISHA
UESHINA BUNMEIDO

EPAC-31746.4

April 12, 1984 Fi/ba


Method and Apparatus for Proofing Multicolor Prints


This invention relates to a method and apparatus for
proofing multicolor prints.


Generally, in order to prepare multicolor prints, filters
essentially filtering the three primary colors and black
color are used to perform color decomposition exposure
of multicolor manuscripts for respective colors to be
developed, several resulting white and black decomposition
negative or positive images are baked or transferred
onto photosensitive recording surfaces comprising
aluminium sheets formed with photosensitive resin layers,
for example, and then negative or positive plates are
corrected by repeating a number of correction superposition printings with a printing press thus obtaining
final printing plates.


The negative or positive plates of the three principal
colors and white and black color can also be prepared by
photographic decomposition process or scanning decomposition process. However, in the case of a multicolor
printing, especially in the case of printing calendars
or posters, customers often request to change color tone
from the manuscript, deletion of unnecessary portions,
vignetting treatments, synthesizing  etc. so that it is
necessary to make many corrections. For this reason, the
correction made by the provisional printing described
above not only requires substantial time but also accompanies substantial loss of material.

Accordingly, it is an object of this invention to provide an improved method capable of greatly reducing the proofing time of multicolor prints and greatly saving necessary materials and to provide an improved apparatus for proofing multicolor prints having a simpel construction and easy to manipulate but can prepare a multicolor photograph having an excellent quality.

According to one aspect of this invention, there is provided a method of proofing a multicolor prints comprising the steps of preparing a plurality of white and black decomposition negative plates from a multicolor manuscript with photographic decomposition or scanning decomposition process; sequentially positioning said negative plates on an illuminating box; projecting image of said positioned plates in sequence upon a photosensitive member through a selected filter and a lens with a predetermined magnifying factor, pint and exposure time, thus preparing a multicolor photograph; correcting color of a negative plate of predetermined color composition in accordance with a desired color correction; repreparing a corrected multicolor photograph with the same magnifying factor, pint and exposure time as above described; and repeating the correcting process described above for respective colors to obtain final plates for printing.

According to another aspect of this invention, there is provided a proofing apparatus of a multicolor print comprising an illuminating box containing a light source and provided with positioning pins for positioning a negative plate obtained by color decomposition of a multicolor manuscript on said illuminating box; a black box disposed above said illuminating box; a pack containing a photosensitive member and mounted on said black box; a complementary rotatable filter, a lens and a motor-driven shutter which are disposed beneath said black box; said negative plate, said lens and said pack being disposed along the same optical axis; and an electric controller for said light source and said motor-driven shutter.

As according to this invention, since the negative plate, supporting member, and the member for supporting the pack of the photosensitive member and the lens are always aligned with the optical axis of the negative plate, the photosensitive member can be illuminated with the image of the negative plates through the lens. When the electronic timer is properly set for a given negative plate and then the motor-operated shutter is opened, exposure of a predetermined time can be assured. Consequently, even when a certain time is required to negotiate with a customer, the same color photograph can always be obtained. Thus, when it is desired to change the color at the time of proofing a color photograph, one or more of negative plates are corrected to obtain a color photograph having the desired color tone.

Moreover, by fixing the magnifying power, print and exposure time, even a not skilled person can readily prepare a color photograph in a short time. When compared with prior arts in which printings are repeated several times, the time necessary for preparing a color photograph can be reduced greatly. For example, according to the prior arts, it was necessary about one day, whereas according to the method if this invention this time can be reduced to only about 15 minutes. Of course, correction of negative plates can be made with a pencil, dye, an air brush or a mask.

Embodiments of the invention are further explained by

- 4 -                                    0134396

means of drawings.

Fig. 1               is a perspective view of the proofing
                     apparatus embodying the invention,

Figs. 2A and 2B  are front view and rear view of a pack
                     of a photosensitive member, respectively;
                     and

Fig. 3               is a side view of a black box.

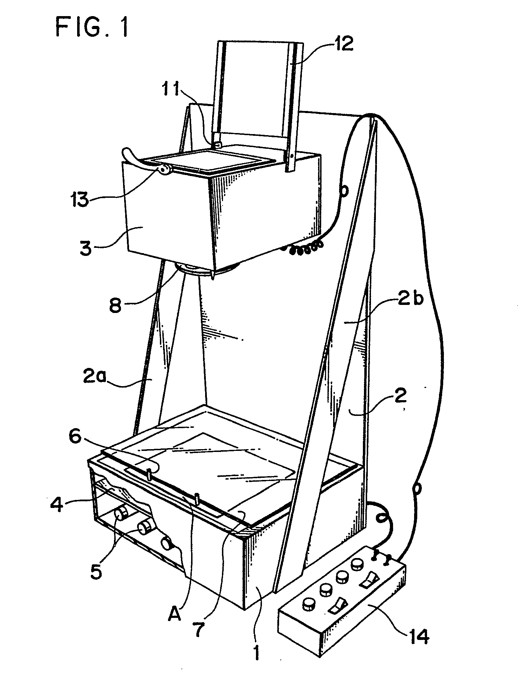

The proofing apparatus illustrated in Figs. 1 through 3 is constituted by a rectangular illuminating box 1, a light shielding vertical supporting plate 2 secured to the rear surface of the illuminating box 1 and a black box 3 secured to the upper portion of the supporting plate 2. The illuminating box 1 and the supporting plate 2 are reinforced by inclined bars 2a and 2b. A light dispersing plate 4 and a light source 5 are disposed in the illuminating box 1. The upper surface of the illuminating box 1 constitutes a support for a color decomposed negative plate A, and is provided with positioning pins 6 which extends through openings of the negative plate A for securely holding the same. A negative plate clamping plate 7 made of acrylic resin, for example, is mounted on the negative plate A. A complementary rotatable filter 8, a lens 9 and a motor-driven shutter 10 are disposed on the lower side of the black box 3 along the optical axis of the negative plate A. A transparent clamping plate 12 for clamping a pack 15 of a photosensitive member is connected to the upper rear edge of the black box 3 with a hinge 11. The main surface of the pack clamping plate 12 is made of pint glass and the clamping plate 12 is secured by a fixture 13. An electric controller 14 is electrically connected to the light source 5 and the motor-operated shutter 10. The electric controller 14 comprises a plurality of electronic timers and timer switches each of the number corresponding to the number of decomposed negative plates, a shutter switch, a source switch and display lamps corresponding to respective negative plates.

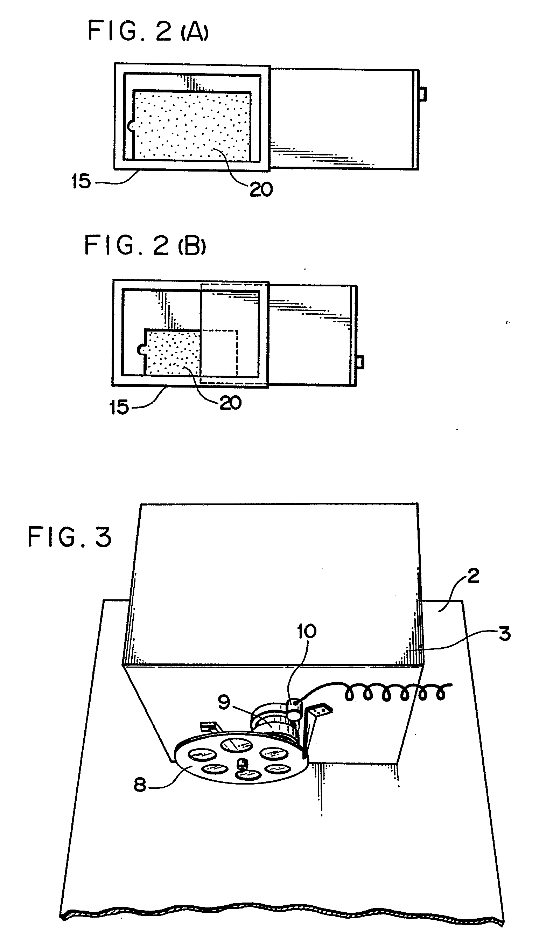

Figs. 2A and 2B illustrate examples of the pack 15 of the photosensitive member, in which the photosensitive member 20 shown in Fig. 2B is smaller than that shown in Fig. 2A.

The clamping member 12 for clamping the pack 15 of the photosensitive member may have the following dimensions, for example;

(1) front surface 8 x 10 inches, rear surface 5 x 7 inches
(2) front surface 8 x 10 inches, rear surface 4 x 5 inches
(3) front surface 5 x 7 inches, rear surface 4 x 5 inches.

The above described proofing apparatus is operated as follows. Each decomposed negative plate A is engaged with positioning pins 6 and then held under pressure by the negative plate clamping plate 7. Then, a filter 8 of a color tone corresponding to the negative plate A is selected by rotating the filter 8. Thereafter, a pack 15 of the photosensitive member is mounted on the black box 3 and secured in position with the pack clamping plate 12 and the fixture 13. During use, the proofing apparatus is covered with a suitable black cloth. After lighting the light source 5, the electronic timer 14 is set to a time calculated in accordance with the characteristics of the negative plate A and the photosensitive member 20 and then the motor-operated shutter 10 is opened. The operation described above is repeated for each color to obtain a color photograph.

When synthesizing a color photograph by using four color decomposed negative plates of green, blue, red and black colors, the pack supporting member must be fixed to make pint alignment unnecessary. The exposure time is also fixed for a given negative plate. For example, 5 sec. for blue, 3 sec. for green, 5 sec. for red and 3 sec. for black. As the positioning pins 16 are used, no misalignment on positionings of negative plates A occurs. When the magnifying power, pint and exposure time are fixed, it is always possible to obtain color photographs of excellent and uniform quality.

A method of proofing multicolor prints will now be described. In this method, color of a multicolor print is changed by correcting a color of corresponding negative plate.

At first, a plurality of color-decomposed white and black negative plates are manufactured from a multicolor manuscript according to well known photographic decomposition or scanning decomposition technique. Usually four color decomposition negative plates of blue, green, red and black colors are used. Then, a multicolor photograph is prepared by using the proofing apparatus described above. The obtained color photograph is used for proofing. If necessary, it may be enlarged by projection. When a required color correction is determined, one or more of negative plates are corrected by using a color tone table, a neutral density filter etc., in accordance with a desire of color correction. All the negative plates including corrected ones are again mounted on the proofing apparatus for obtaining corrected photograph, in which each negative plate is treated with a present multiplying power, pint and exposure time without changing the operating conditions. Should the operating conditions change, colors other than a color whose tone is to be corrected would change, thus nullifying the object of the proofing. By repeating the above processes, a desirable color photograph can be obtained and its negative plates are used for printing.

CLAIMS

1. A method of proofing a multicolor print comprising the steps of:

preparing a plurality of white and black decomposition negative plates from a multicolor manuscript with photographic decomposition or scanning decomposition process;

sequentially positioning said negative plates on an illuminating box;

projecting image of said positioned plates in sequence upon a photosensitive member through a selected filter and a lens with a predetermined magnifying factor, pint and expore time, thus preparing a multicolor photograph;

correcting color of a negative plate of predetermined color composition in accordance with a descired color correction;

repreparing a corrected multicolor photograph with the same magnifying factor, pint and exposure time as above described; and

repeating the correcting process described above for respective colors to obtain final plates for printing.

2. A proofing apparatus of a multicolor print comprising:

an illuminating box (1) containing a light source (5) and provided with positioning pins (6) for positioning a negative plate (A) obtained by color decomposition of a multicolor manuscript on said illuminating box;

a black box (3) disposed above said illuminating box (1);

a pack (15) containing a photosensitive member (20) and mounted on said black box (3);

a complementary rotatable filter (8), a lens (9) and a motor driven shutter (10) which are disposed beneath said black box (3);

said negative plate (A), said lens (9) and said pack (15) being disposed along the same optical axis; and

an electric controller (14) for said light source (5) and said motor driven shutter (10).

3. The proofing apparatus according to claim 2 which further comprises a light dispersing plate (4) disposed between said light source (5) and said negative plate (A) and a clamping plate (7) for clamping said negative plate (A).

4. The proofing apparatus according to claim 2 which further comprises a releasable pack-clamping plate (12) hinged to one side edge of said black box (3) for releasably clamping said pack (15).

5. The proofing apparatus according to claim 2 wherein said controller (14) comprises a plurality of timers of the same number as that of color decomposed negative plates (A) of the multicolor manuscripts, a shutter operating switch and display lamps.

6. The proofing apparatus according to claim 4 wherein said pack clamping plate (12) comprises a transparent pint glass plate.

FIG. 1

FIG. 2 (A)

15    20

FIG. 2 (B)

15    20

FIG. 3

2

3

10

9

8

## DOCUMENTS CONSIDERED TO BE RELEVANT

| Category | Citation of document with indication, where appropriate, of relevant passages | Relevant to claim | CLASSIFICATION OF THE APPLICATION (Int. Cl. ³) |
|---|---|---|---|
| Y | DE-A-3 003 318 (M.D. INGALLS et al.) * Complete document * | 1,2 | G 03 F 3/04 G 03 B 27/73 |
| Y | DE-A-2 136 065 (CIBA-GEIGY) * Complete document * | 1,2 | |
| Y | DE-B-2 600 901 (TOPPAN PRINTING) * Figure 20 * | 1,2 | |
| Y | DE-A-2 618 702 (TIOXIDE GROUP) * Figure * | 1,2 | |
| Y | US-A-2 586 378 (W.E. POHL) * Figure * | 1,2 | |
| Y | FR-A- 834 678 (J. BAZIRE) * Figures 1, 2 * | 1,2 | TECHNICAL FIELDS SEARCHED (Int. Cl. ³) G 03 B 27/00 G 03 B 33/00 G 03 C 7/00 |
| Y | DE-B-2 461 172 (J.M. WEISS) * Figure 3 * | 1,2 | G 03 F 3/00 |
| A | DE-U-1 978 941 (S. MAYER) | | |

The present search report has been drawn up for all claims

| Place of search | Date of completion of the search | Examiner |
|---|---|---|
| BERLIN | 15-08-1984 | HOPPE H |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82